(19) Europäisches Patentamt
European Patent Office
Office européen des brevets

(11) **EP 4 290 567 A1**

(12) **EUROPEAN PATENT APPLICATION**

(43) Date of publication:
**13.12.2023 Bulletin 2023/50**

(21) Application number: **22205150.0**

(22) Date of filing: **02.11.2022**

(51) International Patent Classification (IPC):
**H01L 23/00** (2006.01)     **H01L 33/38** (2010.01)
**B81C 3/00** (2006.01)      **H01L 25/075** (2006.01)
**H01L 25/16** (2023.01)     **H01L 33/00** (2010.01)
**H01L 27/146** (2006.01)

(52) Cooperative Patent Classification (CPC):
**H01L 24/95; B81C 3/005; H01L 27/14601;**
**H01L 33/38;** H01L 25/0753; H01L 25/167;
H01L 27/14618; H01L 33/0095; H01L 2224/16;
H01L 2224/95001; H01L 2224/95085

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **08.06.2022 KR 20220069544**

(71) Applicants:
• **Samsung Electronics Co., Ltd.**
  **Gyeonggi-do 16677 (KR)**
• **Chungbuk National University**
  **Industry-Academic**
  **Cooperation Foundation**
  **Cheongju-si, Chungcheongbuk-do 28644 (KR)**

(72) Inventors:
• **HWANG, Kyungwook**
  **Suwon-si (KR)**

• **JEONG, Jaewook**
  **Cheongju-si (KR)**
• **HWANG, Junsik**
  **Suwon-si (KR)**
• **KIM, Dongkyun**
  **Suwon-si (KR)**
• **KIM, Dongho**
  **Suwon-si (KR)**
• **KIM, Hyunjoon**
  **Suwon-si (KR)**
• **PARK, Joonyong**
  **Suwon-si (KR)**
• **HONG, Seogwoo**
  **Suwon-si (KR)**
• **SONG, Sanghoon**
  **Suwon-si (KR)**
• **YU, Minchul**
  **Suwon-si (KR)**

(74) Representative: **Elkington and Fife LLP**
**Prospect House**
**8 Pembroke Road**
**Sevenoaks, Kent TN13 1XR (GB)**

(54) **MICRO CHIP AND DISPLAY APPARATUS INCLUDING THE SAME**

(57) Provided is a microchip including a chip body having a first surface and a second surface facing the first surface, and an electrode layer on the second surface, wherein a surface roughness of the first surface is smaller than a surface roughness of an upper surface of the electrode layer such that van der Waals force between the first surface and an external contact surface are greater than van der Waals force between the electrode layer and the external contact surface.

FIG. 1

**Description**

FIELD OF THE INVENTION

Example embodiments of the present disclosure relate to a microchip and a display apparatus including the same, and more particularly, to a microchip having a structure suitable for alignment in a fluidic self-assembly method and a display apparatus including the same.

BACKGROUND OF THE INVENTION

Light-emitting diodes (LEDs) have increased industrial demand because of their advantages of low power consumption and eco-friendliness, and are used for lighting devices or liquid crystal display (LCD) backlights, and also applied as pixels of display apparatuses. Recently, a micro LED display apparatus using a micro-sized LED chip as a pixel has been developed. In manufacturing a display apparatus using a micro-sized LED chip, a laser lift off or pick and place method is used as a method of transferring the micro LED. However, in this method, as the size of the micro LED becomes smaller and the size of the display apparatus increases, productivity is lowered.

SUMMARY OF THE INVENTION

One or more example embodiments provide a microchip having a structure suitable for alignment in a fluidic self assembly method.

One or more example embodiments also provide a display apparatus that may be manufactured in a fluidic self assembly method.

Additional aspects will be set forth in part in the description which follows and, in part, will be apparent from the description, or may be learned by practice of example embodiments of the disclosure.

According to an aspect of an example embodiment, there is provided a microchip including a chip body having a first surface and a second surface facing the first surface, and an electrode layer on the second surface, wherein a surface roughness of the first surface is smaller than a surface roughness of an upper surface of the electrode layer such that van der Waals force between the first surface and an external contact surface are greater than van der Waals force between the electrode layer and the external contact surface.

A width of the first surface may be greater than a distance between the first surface and the upper surface of the electrode layer.

A width of the first surface may be in a range from 5 $\mu$m to 500 $\mu$m.

A distance between the first surface and the upper surface of the electrode layer may be in a range from 1 $\mu$m to 100 $\mu$m.

A root mean square (rms) roughness of the first surface may be less than or equal to 1 nm, and a rms roughness of the upper surface of the electrode layer may be greater than or equal to 2 nm.

The rms roughness of the first surface may have a uniformity within $\pm$20% over an entire area of the first surface, and the rms roughness of the upper surface of the electrode layer may have a uniformity of at least $\pm$30% over an entire area of the upper surface of the electrode layer.

An area of the first surface may be greater than an area of the second surface.

The chip body may include a first semiconductor layer doped with a first conductivity type, a light-emitting layer on an upper surface of the first semiconductor layer, a second semiconductor layer on an upper surface of the light-emitting layer and doped with a second conductivity type electrically opposite to the first conductivity type, an insulating layer on an upper surface of the second semiconductor layer, and a planarization layer on a lower surface of the first semiconductor layer, wherein the first surface is a lower surface of the planarization layer and the second surface is an upper surface of the insulating layer.

The electrode layer may include a first electrode on the upper surface of the insulating layer and electrically connected to the first semiconductor layer, and a second electrode on the upper surface of the insulating layer and electrically connected to the second semiconductor layer.

The planarization layer may include at least one of aluminum nitride, polyimide, and parylene.

The microchip may further include a plurality of light-scattering patterns in the first semiconductor layer.

The light-scattering patterns may penetrate the planarization layer and have an engraved form protruding from the lower surface of the first semiconductor layer.

The first surface may be a single surface that is not separated by the light-scattering patterns.

The plurality of light-scattering patterns may have an engraved form protruding from the lower surface of the first semiconductor layer in contact with an upper surface of the planarization layer.

The microchip may further include a plurality of light-scattering patterns having an engraved form protruding from an upper surface of the planarization layer in contact with the first semiconductor layer.

The first surface may be hydrophilic.

The microchip may include at least one of a light-emitting diode (LED), a laser diode, a photodiode, a complementary metal-oxide-semiconductor (CMOS), a high-electron-mobility transistor (HEMT), a thin-film battery, and an antenna element.

According to another aspect of an example embodiment, there is provided a display apparatus including a display substrate including a driving circuit, and a plurality of microchips on the display substrate, wherein each of the plurality of microchips includes a chip body having a first surface and a second surface facing the first surface, and an electrode layer on the second surface, wherein a surface roughness of the first surface is smaller than a surface roughness of an upper surface of the electrode layer such that van der Waals force between the first surface and an external contact surface are greater than van der Waals force between the electrode layer and the external contact surface.

The display substrate may include a plurality of grooves, and a partition wall adjacent to the plurality of grooves, wherein each of the plurality of microchips is in a corresponding groove among the plurality of grooves.

In each groove, a bottom surface of the groove may have a root mean square (rms) roughness less than or equal to 1 nm.

Each of the plurality of microchips may be disposed such that the first surface contacts a bottom surface of the groove within the groove.

A width of the first surface may be greater than a distance between the first surface and the upper surface of the electrode layer.

A width of the first surface may be in a range from 5 $\mu$m to 500 $\mu$m.

A distance between the first surface and the upper surface of the electrode layer may be in a range from 2 $\mu$m to 100 $\mu$m.

A rms roughness of the first surface may be less than or equal to 1 nm, and a rms roughness of the upper surface of the electrode layer may be greater than or equal to 2 nm.

The rms roughness of the first surface may have a uniformity within $\pm20\%$ over an entire area of the first surface, and the rms roughness of the upper surface of the electrode layer may have a uniformity of at least $\pm30\%$ over an entire area of the upper surface of the electrode layer.

An area of the first surface may be greater than an area of the second surface.

The display substrate may include a plurality of first electrode pads and a plurality of second electrode pads on an upper surface of the display substrate, and the electrode layer of each of the plurality of microchips may include a first electrode in contact with a first electrode pad among the plurality of first electrode pads and a second electrode in contact with a second electrode pad among the plurality of second electrode pads.

BRIEF DESCRIPTION OF THE DRAWINGS

The above and/or other aspects, features, and advantages of example embodiments of the disclosure will be more apparent from the following description taken in conjunction with the accompanying drawings, in which:

FIG. 1 schematically shows a structure of a microchip according to an example embodiment;

FIGS. 2 and 3 schematically show a principle of aligning a microchip in one direction;

FIG. 4 is a graph exemplarily showing a relationship between a ratio of microchips aligned in the same direction among all microchips and the number of times an external force is applied to a substrate;

FIG. 5 is a cross-sectional view showing a structure of a microchip in more detail when the microchip is a light-emitting element according to an example embodiment;

FIGS. 6A, 6B, 6C, and 6D are plan views illustrating various electrode structures of a microchip according to example embodiments;

FIGS. 7A and 7B are scanning electron microscope (SEM) images illustrating an upper surface and a lower surface of a microchip, respectively;

FIGS. 8A and 8B are atomic force microscopy (AFM) images of different regions of an upper surface of a microchip, and FIG. 8C is an AFM image of a lower surface of a microchip;

FIG. 9A is a graph exemplarily showing an adhesion force due to van der Waals forces measured at a plurality of different positions on an upper surface of a microchip, and FIG. 9B is a graph exemplarily showing an adhesion force due to van der Waals forces measured at a plurality of different positions on a lower surface of a microchip;

FIG. 10 is a cross-sectional view schematically illustrating a structure of a microchip according to another example embodiment;

FIG. 11 is a cross-sectional view schematically illustrating a structure of a microchip according to another example embodiment;

FIGS. 12A and 12B are cross-sectional views and plan views, respectively, schematically showing a structure of a microchip according to another example embodiment;

FIG. 13 is a perspective view illustrating a method of aligning a plurality of microchips using a fluidic self-assembly method;

FIG. 14 schematically shows a scanning process for aligning a microchip;

FIG. 15 is a cross-sectional view showing a schematic structure of a transfer substrate according to an embodiment in which microchips are aligned;

FIGS. 16A and 16B are cross-sectional views schematically illustrating a process of manufacturing a display apparatus according to an embodiment by transferring a microchip aligned on a transfer substrate onto a display substrate;

FIG. 17 is a cross-sectional view schematically illustrating a structure of a display apparatus according to another example embodiment;

FIG. 18 is a cross-sectional view schematically showing a structure of a display apparatus according to another example embodiment;

FIG. 19 is a cross-sectional view schematically showing a structure of a display apparatus according to another example embodiment;

FIG. 20 is a schematic block diagram of an electronic device according to an example embodiment;

FIG. 21 illustrates an example in which a display apparatus according to embodiments is applied to a mobile device;

FIG. 22 shows an example in which a display apparatus according to embodiments is applied to a display apparatus for a vehicle;

FIG. 23 illustrates an example in which a display apparatus according to embodiments is applied to augmented reality glasses or virtual reality glasses;

FIG. 24 illustrates an example in which a display apparatus according to embodiments is applied to a signage; and

FIG. 25 illustrates an example in which a display apparatus according to embodiments is applied to a wearable display.

DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, a microchip and a display apparatus including the same will be described in detail with reference to the accompanying drawings. In the following drawings, the same reference numerals refer to the same components, and the size of each component in the drawings may be exaggerated for clarity and convenience of description. Further, the example embodiments described below are merely exemplary, and various modifications are possible from these example embodiments.

Hereinafter, what is described as "upper part" or "on" may include not only those directly above by contact, but also those above non-contact. The terms of a singular form may include plural forms unless otherwise specified. In addition, when a certain part "includes" a certain component, it means that other components may be further included rather than excluding other components unless otherwise stated.

The use of the term "the" and similar designating terms may correspond to both the singular and the plural. If there is no explicit order or contradictory statement about the steps constituting the method, these steps may be performed in an appropriate order, and are not necessarily limited to the order described.

In addition, terms such as "unit" and "module" described in the specification mean a unit that processes at least one function or operation, and this may be implemented as hardware or software, or may be implemented as a combination of hardware and software.

The connection or connection members of lines between the components shown in the drawings are illustrative of functional connections and/or physical or circuit connections, and may be represented as a variety of functional connections, physical connections, or circuit connections that are replaceable or additional in an actual device.

The use of all examples or illustrative terms is merely for describing technical ideas in detail, and the scope is not limited by these examples or illustrative terms unless limited by the claims.

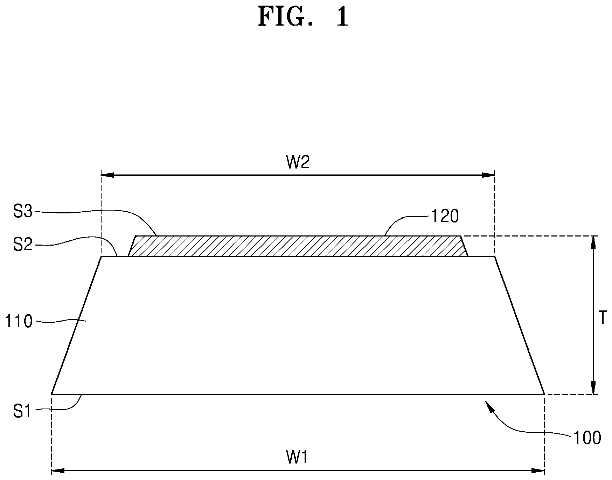

FIG. 1 schematically shows the structure of a microchip according to an example embodiment. Referring to FIG. 1, the microchip 100 according to the example embodiment may include a chip body 110 having a first surface S1 and a second surface S2 facing the first surface S1, and an electrode layer 120 disposed on the second surface S2 of the chip body 110.

The microchip 100 may be configured to be more easily aligned in one direction using a fluidic self assembly method. Then, when aligning the plurality of microchips 100 on an external object such as a substrate using the fluidic self assembly method, most or all of the plurality of microchips 100 may be aligned in the same direction. For example, a plurality of microchips 100 may be aligned such that the first surface S1 of the chip body 110 is in contact with an external object and the upper surface S3 of the electrode layer 120 is not in contact with an external object. Here, the upper surface S3 of the electrode layer 120 is a surface opposite to the surface of the electrode layer 120 in contact with the second surface S3 of the chip body 110.

The microchip 100 may be configured such that the van der Waals force between the first surface S1 of the chip body 110 and the external contact surface is greater than the van der Waals force between the upper surface S3 of the electrode layer 120 and the external contact surface. In this case, when in contact with the first surface S1 of the chip body 110 and the external contact surface, it does not fall off relatively easily, and when the upper surface S3 of the electrode layer 120 comes into contact with the external contact surface, the upper surface S3 of the electrode layer 120 may be detached relatively easily. Accordingly, when aligning the microchip 100, the probability that the microchip 100 is disposed such that the first surface S1 of the chip body 110 comes into contact with the external contact surface may increase.

The van der Waals force may increase as two objects in contact with each other are in close contact with each other or as the contact area between two objects in contact with each other increases. Accordingly, according to an example embodiment, the surface roughness of the first surface S1 of the chip body 110 may be smaller than the surface roughness of the upper surface S3 of the electrode layer 120. For example, the root mean square (rms) roughness of the first surface S1 of the chip body 110 may be 1 nm or less, and the rms roughness of the upper surface S3 of the electrode layer 120 may be 2 nm or more. However, embodiments are not limited thereto. For example, the rms roughness of the upper surface S3 of the electrode layer 120 may be twice or more of the rms roughness of the first surface S1 of the chip body 110. Here, the rms roughness of the first surface S1 of the chip body 110 may be the average rms roughness of the entire area of the first surface S1, and may be different from the rms roughness in a local partial region of the first surface S1 of the chip body 110. Similarly, the rms roughness of the upper surface S3 of the electrode layer 120 may be the average rms roughness of the entire area of the upper surface S3 of the electrode layer 120, and may be different from the rms roughness in a local partial region of the upper surface S3 of the electrode layer 120. As a result, a relatively smooth surface may be formed on the first surface S1, which is the lower portion of the microchip 100, and a relatively rough surface may be formed on the upper surface S3 of the electrode layer 120, which is an upper portion of the microchip 100.

In addition, the area of the first surface S1 of the chip body 110 is larger than the area of the second surface S2 of the chip body 110 and the area of the second surface S2 of the chip body 110 is larger than the area of the upper surface S3 of the electrode layer 120. Accordingly, the area of the first surface S1 of the chip body 110 may be larger than the area of the upper surface S3 of the electrode layer 120. To this end, the radius or width W1 of the first surface S1 of the chip body 110 may be greater than the radius or width W2 of the second surface S2 of the chip body 110. For example, the radius or width W2 of the second surface S2 may be 0.7 times or more and less than 1 time, or 0.8 times or more and 0.95 times or less, the radius or width W1 of the first surface S1. Accordingly, the side surface of the microchip 100 may have an inclined shape.

The microchip 100 may have a small size of sub millimeter (mm) or less. For example, the radius or width W1 of the first surface S1 of the chip body 110 may be in the range of about 5 $\mu$m to about 500 $\mu$m, or in the range of about 10 $\mu$m to about 300 $\mu$m.

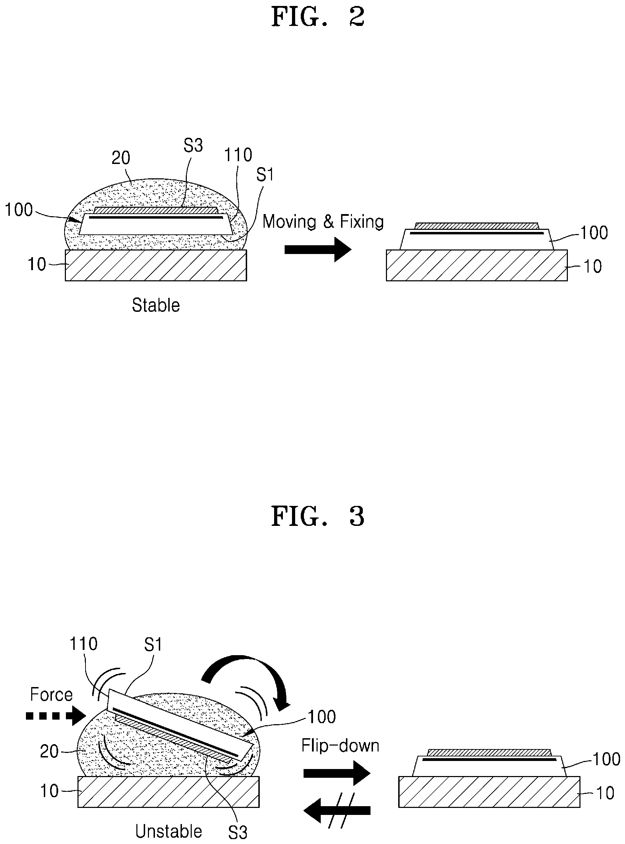

FIGS. 2 and 3 schematically show the method of aligning the microchip 100 in one direction. Referring to FIGS. 2 and 3, the microchip 100 may move freely in the fluid 20 by an external force. As shown in FIG. 2, when the upper surface S3 of the electrode layer 120 faces upward and the first surface S1 of the chip body 110 comes into contact with the substrate 10, since the van der Waals force between the first surface S1 of the chip body 110 and the substrate 10 is relatively large, the microchip 100 is in a stable state and maintains its orientation. On the other hand, as shown in FIG. 3, when the first surface S1 of the chip body 110 faces upward and the upper surface S3 of the electrode layer 120 comes into contact with the substrate 10, the van der Waals force between the upper surface S3 of the electrode layer 120 and the substrate 10 is relatively weak, resulting in an unstable state. Then, the microchip 100 may be easily separated from the substrate 10 by an external force. When the microchip 100 away from the substrate 10 is turned over in the opposite direction by an external force, the microchip 100 is pressed and positioned with the substrate 10, and the reverse phenomenon may no longer occur. Therefore, when an arbitrary external force is repeatedly applied to the plurality of microchips 100 in the fluid 20 to change the direction of the microchips 100, the arrangement direction of the plurality of microchips 100 faces upward in one direction, that is, the first surface S1 of the chip body 110, and converges in a direction in which the upper surface S3 of the electrode layer 120 comes into contact with the substrate 10.

After a single external force is applied to the microchip 100 in the fluid 20 and the upper surface S3 of the electrode layer 120 having a relatively small van der Waals force with the substrate 10 is separated from the substrate 10, when the microchip 100 sinks again, with a probability of 1/2, the first surface S1 of the chip body 110 having a large van der Waals force faces the substrate 10. Assuming that this process is repeated n times, the number of microchips 100 in which the first surface S1 of the chip body 110 faces the substrate 10 may be calculated as the sum of a geometric sequence as in Equation 1 below.

[Equation 1]

$$A_n = a\{1-(1/2)^{n+1}\}$$

In Equation 1 above, a is the total number of microchips 100, n is the number of times an external force is applied, and $A_n$ is the number of microchips 100 in which the first surface S1 of the chip body 110 faces the substrate 10 after n trials.

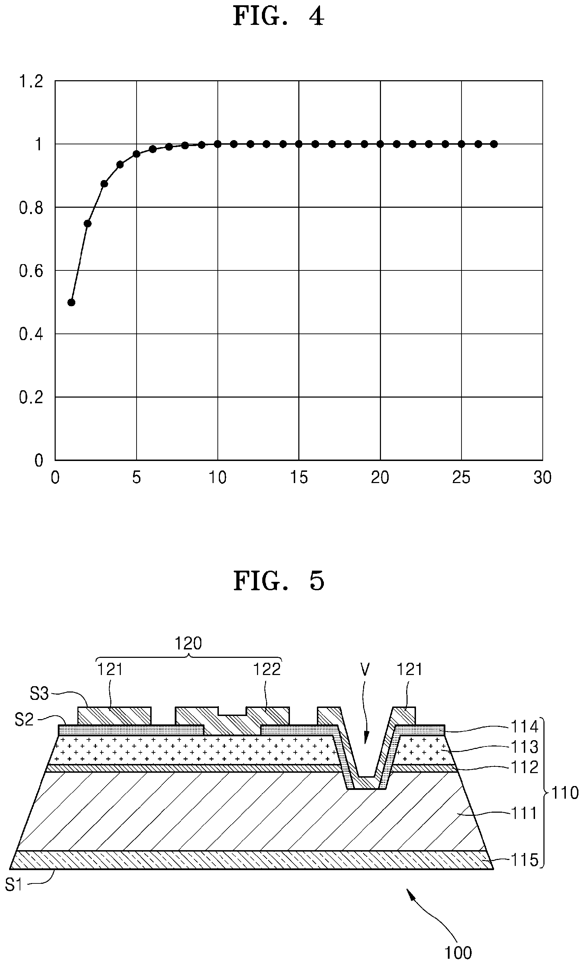

For example, FIG. 4 is a graph exemplarily showing the relationship between the ratio of the microchips 100 aligned in the same direction among all the microchips 100 and the number of times an external force is applied to the substrate 10. Referring to FIG. 4, the ratio of the microchips 100 aligned in the same direction among all the microchips 100 may converge to 1 as the number of times the external force is applied to the substrate 10 increases. As described above, the van der Waals force between the external contact surface such as the substrate 10 and the surfaces of the microchip 100 may be a significant characteristic for irreversibly aligning the microchips 100 in one direction. Using this method, it is possible to relatively easily transfer a large number of microchips 100.

In FIG. 1, when the distance between the first surface S1 of the chip body 110 and the upper surface S3 of the electrode layer 120, that is, the thickness T of the microchip 100, is too large and above a certain value, a force that causes the microchip 100 to fall due to an external force may be greater than an adhesion force due to the van der Waals force. Accordingly, the width W1 of the first surface S1 of the chip body 110 may be greater than the thickness T of the microchip 100. For example, the aspect ratio of the microchip 100 may be greater than 0 and less than 1, or 0.1 or more and 0.5 or less. For example, the distance between the first surface S1 of the chip body 110 and the upper surface S3 of the electrode layer 120 or the thickness T of the microchip 100 may be in the range of about 1 μm to about 100 μm, or in the range of about 1 μm to about 50 μm, or in the range of about 2 μm to about 30 μm.

The microchip 100 may be, for example, a micro light emitting device such as a micro LED (light emitting diode), but is not necessarily limited thereto, and may include any kind of semiconductor chip, electronic circuit chip, or optical circuit chip that may be aligned on a substrate in a fluidic self assembly manner. For example, the microchip 100 may include small light emitting elements such as laser diodes in addition to micro LEDs, light receiving elements such as small photodetectors like photodiodes, small electronic elements such as complementary metal-oxide-semiconductors (CMOS) or high electron mobility transistors (HEMT), thin film batteries, ultra-small antenna elements, and the like. Hereinafter, a case in which the microchip 100 is a micro LED will be described as an example.

FIG. 5 is a cross-sectional view showing the structure of the microchip 100 in more detail when the microchip 100 is a light emitting element according to an example embodiment. Referring to FIG. 5, the chip body 110 may include a first semiconductor layer 111 doped with a first conductivity type, a light emitting layer 112 disposed on the upper surface of the first semiconductor layer 111, a second semiconductor layer 113 disposed on the upper surface of the light emitting layer 112 and doped with a second conductivity type that is electrically opposite to the first conductivity type, an insulating layer 114 disposed on the upper surface of the second semiconductor layer 113, and a planarization layer 115 disposed on the lower surface of the first semiconductor layer 111. In addition, the electrode layer 120 may include a first electrode 121 disposed on the upper surface of the insulating layer 114 and electrically connected to the first semiconductor layer 111 and a second electrode 122 disposed on the upper surface of the insulating layer 114 and electrically connected to the second semiconductor layer 113. In this case, the first surface S1 of the chip body 110 becomes the lower surface of the planarization layer 115, the second surface S2 of the chip body 110 becomes the upper surface of the insulating layer 114, and the upper surface S3 of the electrode layer 120 becomes the upper surface of the first electrode 121 and the second electrode 122.

The first semiconductor layer 111 and the second semiconductor layer 113 may include, for example, a group III-V or group II-VI compound semiconductor. The first semiconductor layer 111 and the second semiconductor layer 113 may serve to provide electrons and holes to the light emitting layer 112. For this, the first semiconductor layer 111 and the second semiconductor layer 113 may be electrically doped with opposite conductivity types. For example, the first semiconductor layer 111 may be doped with n-type and the second semiconductor layer 113 may be doped with p-type, or the first semiconductor layer 111 may be doped with p-type and the second semiconductor Layer 113 may be doped with n-type.

The light emitting layer 112 has a quantum well structure in which quantum wells are disposed between barriers. Light may be generated as electrons and holes provided from the first and second semiconductor layers 111 and 113 are recombined in the quantum well in the light emitting layer 112. The wavelength of light generated from the light emitting layer 112 may be determined according to the energy band gap of the material constituting the quantum well in the light emitting layer 112. The light emitting layer 112 may have only one quantum well, but is not limited thereto, and may have a multi-quantum well (MQW) structure in which a plurality of quantum wells and a plurality of barriers are alternately arranged. The thickness of the light emitting layer 112 or the number of quantum wells in the light emitting layer 112 may be appropriately selected in consideration of the driving voltage and luminous efficiency of the light emitting element.

To more easily align the microchip 100 in a fluidic self assembly method, both the first electrode 121 and the second electrode 122 may be disposed on one surface of the microchip 100. For example, the insulating layer 114 may be formed on the upper surface of the second semiconductor layer 113, and the first electrode 121 and the second electrode 122 may be disposed on the upper surface of the insulating layer 114. To electrically connect the first electrode 121 to the first semiconductor layer 111, the microchip 100 may further include a via hole V penetrating the second semiconductor layer 113 and the light emitting layer 112. Although only one via hole V is illustrated in FIG. 5 for convenience, one or more via holes V may be formed as needed. The insulating layer 114 may extend to be provided adjacent to and surround the sidewall of the via hole V. Accordingly, a portion of the second semiconductor layer 113 exposed by the via hole V and a portion of the light emitting layer 112 may be covered by the insulating layer 114. The first electrode 121 extends from the upper surface of the insulating layer 114 to the upper surface of the first semiconductor layer 111 exposed through the via hole V to contact the first semiconductor layer 111 through the via hole V. The second electrode 122 may be configured to penetrate the insulating layer 114 and contact the second semiconductor layer 113. A portion of the first electrode 121 and the second electrode 122 may further extend in the lateral direction from the upper surface of the insulating layer 114.

To more easily align the microchip 100 in the fluidic self assembly method, the surface roughness (i.e., rms roughness) of the upper surfaces of the first electrode 121 and the second electrode 122 may be 2 nm or more. In addition, to more easily align the microchip 100 in a fluidic self assembly method, the first electrode 121 and the second electrode 122 may be formed of a hydrophobic metallic material to prevent the first electrode 121 and the second electrode 122 of the microchip 100 from closely contacting the external contact surface in the fluid.

The planarization layer 115 provides a first surface S1 for more easily aligning the microchip 100 in a fluidic self assembly method. To this end, the planarization layer 115 may have a very smooth and flat lower surface. For example, the surface roughness (i.e., rms roughness) of the lower surface of the planarization layer 115 may be 1 nm or less.

In addition, the planarization layer 115 may be made of a material having a hydrophilic property. For example, the planarization layer 115 may include at least one of aluminum nitride (AIN), polyimide, and parylene. Accordingly, the first surface S1 of the chip body 110 may have hydrophilicity. Then, in the fluid, the first surface S1 may more easily contact the external contact surface, and the adhesion force with the external contact surface may be further increased.

When the planarization layer 115 includes aluminum nitride (AIN), the planarization layer 115 may serve as a buffer layer for growing the first semiconductor layer 111, the light emitting layer 112, and the second semiconductor layer 113 on a growth substrate such as a silicon substrate. After the microchip 100 is manufactured on the growth substrate, the microchip 100 may be separated from the growth substrate through a chemical lift off method. When the microchip 100 is separated through chemical lift off, the lower surface of the planarization layer 115 made of AIN may have a relatively highly smooth state. When the planarization layer 115 includes polyimide or parylene, after the microchip 100 is manufactured on the growth substrate, the planarization layer 115 may be formed on the lower surface of the first semiconductor layer 111 by, for example, flip chip bonding. Then, for example, a lower surface of the planarization layer 115 may be planarized by a chemical mechanical polishing (CMP) method.

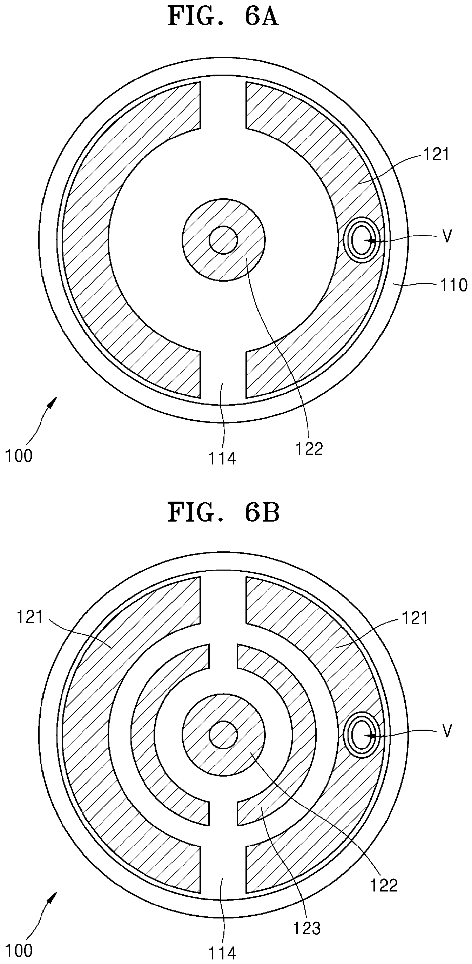

After aligning the microchip 100, electrical wiring may be connected to the first electrode 121 and the second electrode 122. For example, in a process of manufacturing the display apparatus, the first electrode 121 and the second electrode 122 of the microchip 100 may be bonded to corresponding electrode pads on the display substrate. To more easily implement such an electrical connection, the first electrode 121 and the second electrode 122 may have a symmetrical shape. For example, FIGS. 6A to 6D are plan views illustrating various electrode structures of the microchip 100.

Referring to FIG. 6A, the cross-section of the microchip 100 may have a circular shape according to an example embodiment. The second electrode 122 may be disposed at a position corresponding to the center of the microchip 100, that is, the center of the second semiconductor layer 113 in the horizontal direction that is parallel to the upper surface of the second semiconductor layer 113. The second electrode 122 may have a circular shape. However, embodiments are not necessarily limited thereto, and the second electrode 122 may have different shapes such as, for example, a quadrangle or other polygonal shape. The first electrode 121 may be disposed at an edge of the microchip 100, that is, at a position corresponding to the edge of the second semiconductor layer 113 in the horizontal direction. The first electrode 121 may have a symmetrical shape with respect to the second electrode 122. For example, the first electrode 121 may have the form of two broken semicircular rings provided adjacent to and surrounding the perimeter of the second electrode 122. In FIG. 6A, the first electrode 121 is illustrated as having the shape of two broken rings by way of example, but embodiments are not limited thereto. The first electrode 121 may have, for example, the shape of three or four or more broken rings. Even if the first electrodes 121 have disconnected portions, they may be electrically connected to each other when they are bonded to the electrode pads on the display substrate. Although only one via hole V is illustrated in FIG. 6A for convenience, one or more via holes V may be formed as needed.

Referring to FIG. 6B, the microchip 100 may further include a bonding spread prevention wall 123 disposed between the first electrode 121 and the second electrode 122 on the upper surface of the insulating layer 114. When bonding the first electrode 121 and the second electrode 122 to the corresponding electrode pads on the display substrate, the bonding spread prevention wall 123 may prevent, for example, a bonding material such as solder bumps from spreading between the first electrode 121 and the second electrode 122 to prevent a short circuit. The bonding spread prevention wall 123 may have a shape protruding above the upper surface of the insulating layer 114. The thickness of the bonding spread prevention wall 123 may be less than or equal to the thickness of the first electrode 121 and the thickness of the second electrode 122. The bonding spread prevention wall 123 may be made of an electrically insulating material. The bonding spread prevention wall 123 may be disposed in the form of a ring between the first electrode 121 and the second electrode 122. The bonding spread prevention wall 123 may have, for example, the shape of two or more broken rings like the first electrode 121, and may be disposed to completely cover an area between the first electrode 121 and the second electrode 122.

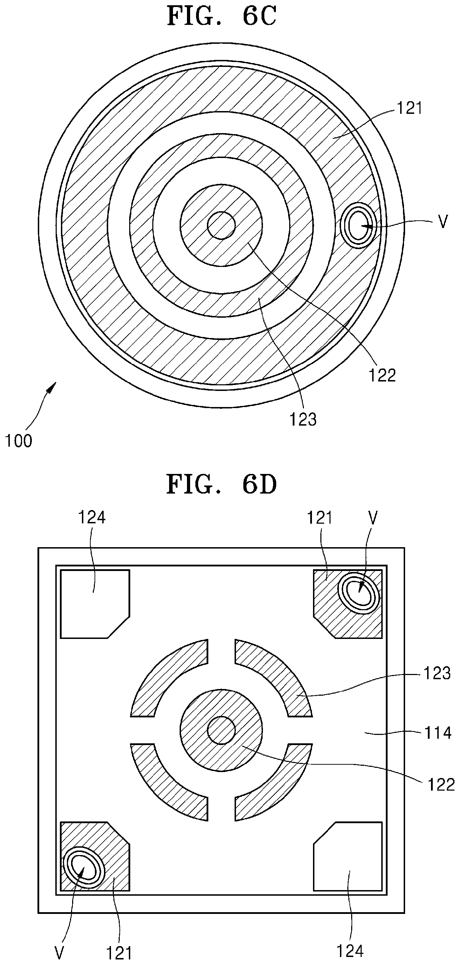

Referring to FIG. 6C, each of the first electrode 121 and the bonding spread prevention wall 123 may have the form of one complete ring according to another example embodiment.

Referring to FIG. 6D, the cross-section of the microchip 100 may have a rectangular shape according to another example embodiment. The second electrode 122 is disposed in the center of the microchip 100 and may have a circular or polygonal shape. The first electrode 121 may be respectively disposed in two vertex regions facing each other in a diagonal direction. In addition, the microchip 100 may further include bonding pads 124 respectively disposed at two different vertex areas facing in different diagonal directions. The bonding pad 124 is bonded on the display substrate when the first electrode 121 and the second electrode 122 of the microchip 100 are bonded to the corresponding electrode pads on the display substrate, such that the microchip 100 may be stably fixed on the display substrate. As another example, the first electrode 121 may be disposed in all four vertex regions without the bonding pad 124.

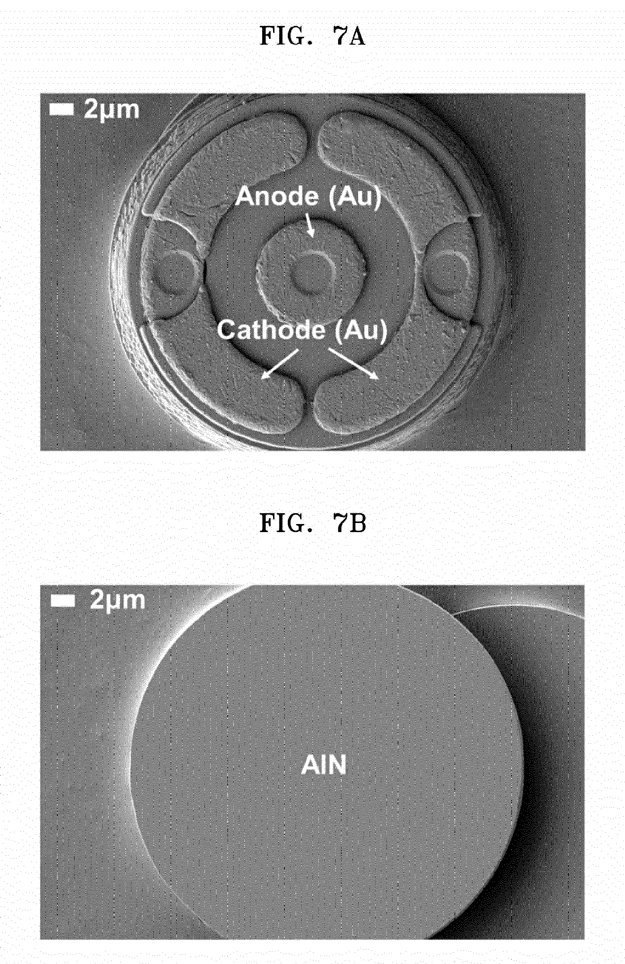

FIGS. 7A and 7B are scanning electron microscope (SEM) images illustrating an upper surface and a lower surface of the microchip 100, respectively. Referring to FIG. 7A, the first electrode 121 and the second electrode 122 positioned on the upper surface of the microchip 100 have relatively rough surfaces. In FIG. 7B, the lower surface of the microchip 100, that is, the first surface S1 has a relatively smooth surface.

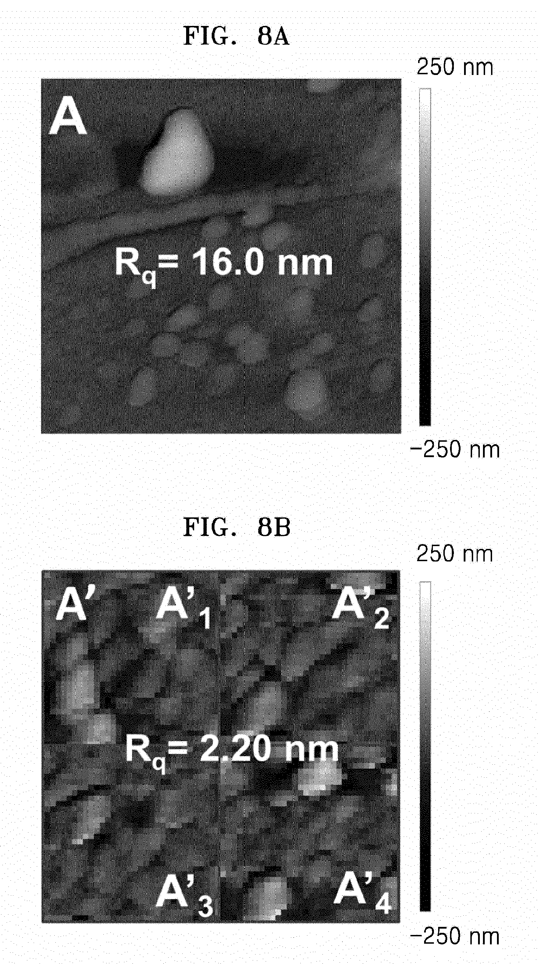

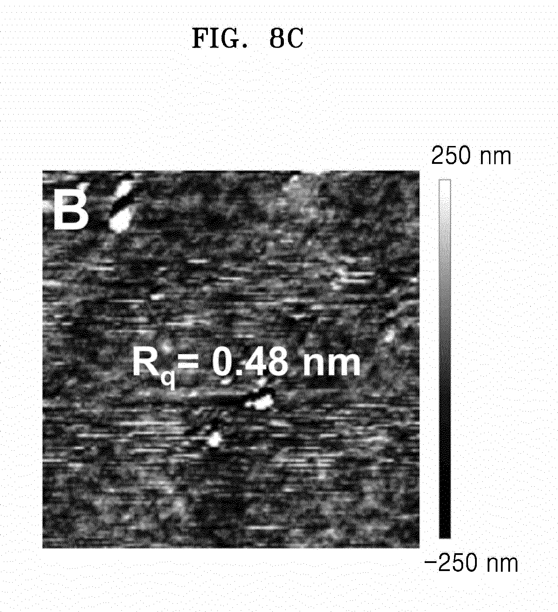

FIGS. 8A and 8B are atomic force microscopy (AFM) images of different regions of the upper surface of the microchip 100, and FIG. 8C is an AFM image of the lower surface of the microchip 100. FIGS. 8A and 8B illustrate that the first electrode 121 and the second electrode 122 have a surface roughness of 2 nm or more. Also, it may be seen that the difference in local surface roughness is relatively large according to the positions of the first electrode 121 and the second electrode 122. On the other hand, FIG. 8C illustrates that the lower surface of the microchip 100, that is, the first surface S1 has a surface roughness of 1 nm or less, for example, about 0.48 nm.

As may be seen from FIGS. 7A to 8C, the surfaces of the first electrode 121 and the second electrode 122 have relatively large surface roughness, and the uniformity of the surface roughness according to positions is relatively low. Accordingly, the adhesion force between the first electrode 121 and the second electrode 122 and the external contact surface due to the van der Waals force may be relatively small and dispersion of the adhesion force may be relatively high. On the other hand, the lower surface of the microchip 100, that is, the first surface S1, has a relatively small surface roughness, and the uniformity of the surface roughness according to the location is relatively high. Accordingly, the adhesion force between the first surface S1 and the external contact surface by the van der Waals force may be relatively large, and the dispersion of the adhesion force may be relatively low.

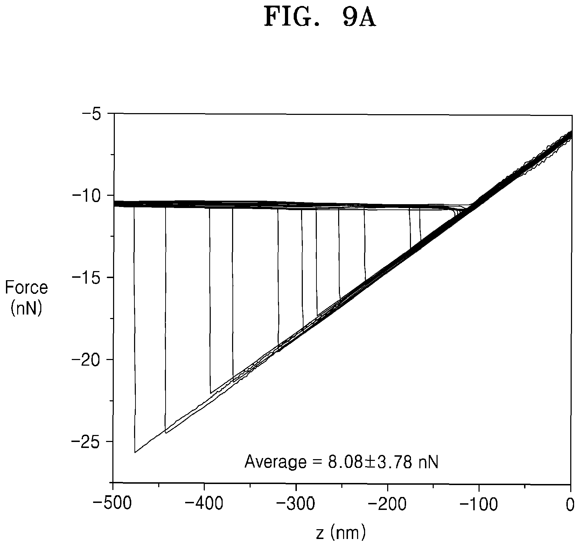

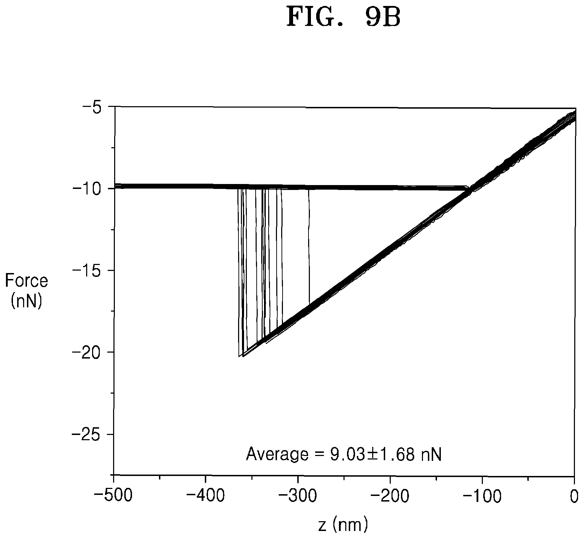

For example, FIG. 9A is a graph exemplarily showing the adhesion force by the van der Waals force measured at a plurality of different positions on the upper surface of the microchip 100, and FIG. 9B is a graph exemplarily showing the adhesion force due to the van der Waals force measured at a plurality of different positions on the lower surface of the microchip 100. In the graphs of FIGS. 9A and 9B, since the force acting on an AFM probe tip was measured and obtained when the AFM probe tip was brought into contact with the sample surface and then removed, the direction of movement of the probe and the direction of the force acting were opposite such that the value of the distance z between the sample surface and the probe tip and the value of the adhesion force were expressed as negative numbers. Therefore, the actual adhesion force and distance may be understood only as absolute values.

FIG. 9A illustrates that the dispersion of the adhesion force according to the position on the upper surface of the microchip 100 is relatively large. This is because the dispersion according to the position of the surface roughness of the upper surfaces of the first electrode 121 and the second electrode 122 is large. FIG. 9B illustrates that the dispersion of the adhesion force according to the position on the lower surface of the microchip 100 is relatively small. This is because the dispersion according to the position of the surface roughness of the lower surface of the microchip 100 is small. For example, the rms roughness of the first surface S1 has a uniformity within ±20% over the entire area of the first surface S1, and the rms roughness of the upper surfaces of the first electrode 121 and the second electrode 122 may have a uniformity of ±30% or more over the entire area of the upper surfaces of the first electrode 121 and the second electrode 122.

In addition, referring to FIGS. 9A and 9B, it may be confirmed that the average adhesion force on the lower surface of the microchip 100 is greater than the average adhesion force on the upper surface of the microchip 100. Accordingly, the lower surface of the microchip 100 may be more easily attached to the external contact surface than the upper surface. This adhesion force may be expressed by the following Equation 2.

[Equation 2]

$$F_{ad} = \frac{A_H A}{6H_0^2} \left[ \rho r + \frac{1}{\pi H_0 (1 + y_{max}/H_0)^3} \right]$$

In Equation 2 above, $A_H$ is Hamaker's constant, A is the contact area between the two surfaces, Ho is the cut-off distance between the surface of the microchip 100 and the external contact surface, $y_{max}$ is the surface roughness, r is the radius of the surface asperity, and p is the number density. As may be seen from Equation 2, as the contact area between the two surfaces is larger and the surface roughness is smaller, adhesion may increase. Therefore, in the microchip 100 according to the embodiment, the first surface S1 of the chip body 110 has an adhesion force with the external contact surface expressed by Equation 2 greater than that of the upper surface S3 of the electrode layer 120.

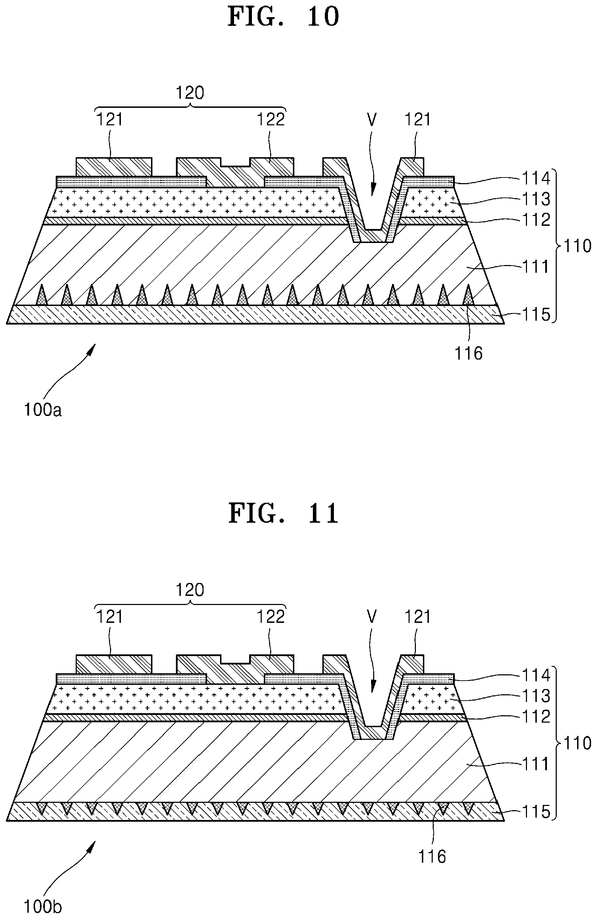

FIG. 10 is a cross-sectional view schematically illustrating a structure of a microchip according to another example embodiment. Referring to FIG. 10, the microchip 100a may further include a plurality of light scattering patterns 116 disposed in the first semiconductor layer 111. The light scattering pattern 116 may be made of air, a void, a transparent dielectric material, or a semiconductor material different from that of the first semiconductor layer 111. The light scattering pattern 116 may have an engraved shape protruding from the lower surface of the first semiconductor layer 111 in contact with the upper surface of the planarization layer 115. The width, thickness, shape of the light scattering pattern 116, or an interval between the light scattering patterns 116 may be irregularly distributed. Accordingly, light generated from the light emitting layer 112 may be relatively uniformly emitted to the outside by the irregular light scattering pattern 116 in the first semiconductor layer 111.

FIG. 11 is a cross-sectional view schematically illustrating a structure of a microchip according to another example embodiment. Referring to FIG. 11, the microchip 100b may include a plurality of light scattering patterns 116 disposed in the planarization layer 115 instead of the first semiconductor layer 111. For example, the light scattering pattern 116 may have an engraved shape protruding from the upper surface of the planarization layer 115 in contact with the first semiconductor layer 111.

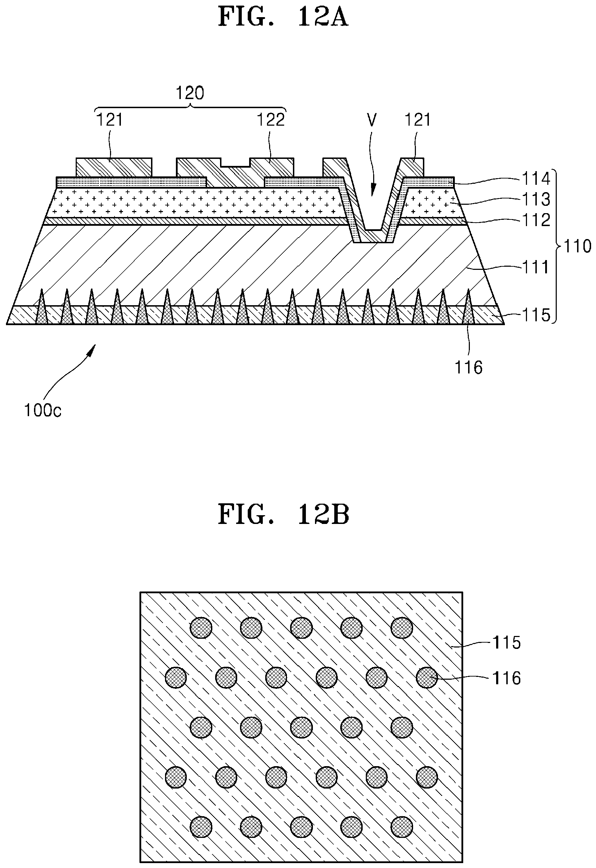

FIGS. 12A and 12B are cross-sectional and plan views schematically showing the structure of a microchip according to another example embodiment, respectively. Referring to FIG. 12A, the microchip 100c may include a plurality of light scattering patterns 116 having an engraved shape protruding from the lower surface of the first semiconductor layer 111 through the planarization layer 115.

Referring to FIG. 12B, a plurality of light scattering patterns 116 may be arranged two-dimensionally and spaced apart from each other. In this case, the surface roughness of the first surface of the chip body 110 of the microchip 100c, that is, the lower surface of the planarization layer 115 may be measured except for the plurality of light scattering patterns 116. Since the plurality of light scattering patterns 116 have an island shape separated from each other, the lower surface of the planarization layer 115 may have a single surface that is not separated by the plurality of light scattering patterns 116. Therefore, even if the light scattering pattern 116 is formed through the planarization layer 115, the adhesion force between the lower surface of the planarization layer 115 and the external contact surface may not be significantly reduced.

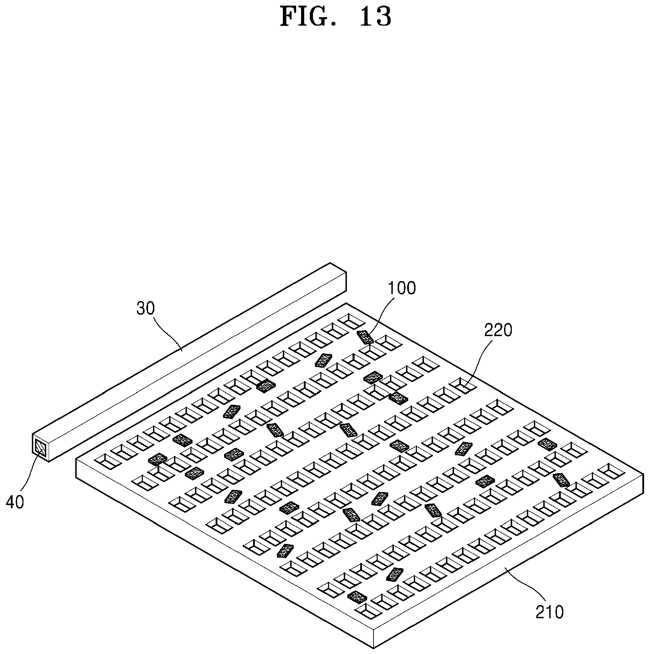

FIG. 13 is a perspective view exemplarily showing a method of aligning a plurality of microchips 100 using a fluidic self assembly method according to an example embodiment. Referring to FIG. 13, the plurality of microchips 100 may be supplied on the upper surface of the transfer substrate 210 having the plurality of two-dimensionally arranged grooves 220. After supplying the liquid to the groove 220 of the transfer substrate 210, the plurality of microchips 100 may be directly sprayed on the transfer substrate 210 or supplied on the transfer substrate 210 in a state included in a suspension. Although the microchip 100 shown in FIG. 5 is used in FIG. 13, the microchips 100a, 100b, and 100c according to other example embodiments may be used.

The liquid supplied to the groove 220 may be any kind of liquid as long as it does not corrode or damage the microchip 100, and may be supplied to the groove 220 by various methods, such as a spray method, a dispensing method, an inkjet dot method, a method for flowing a liquid to the transfer substrate 210, and the like. The liquid may include, for example, one or a combination of a plurality of groups including water, ethanol, alcohol, polyol, ketone, halocarbon, acetone, flux, and organic solvent. The organic solvent may include, for example, isopropyl alcohol (IPA). The amount of liquid supplied may be varied to fit or overflow from the groove 220.

The plurality of microchips 100 may be directly sprayed on the transfer substrate 210 without any other liquid, or may be supplied on the transfer substrate 210 in a state included in a suspension. As a supply method of the microchip 100 included in the suspension, a spray method, a dispensing method for dropping a liquid, an inkjet dot method for discharging a liquid like a printing method, a method for flowing a suspension to the transfer substrate 210, and the like may be used in various ways.

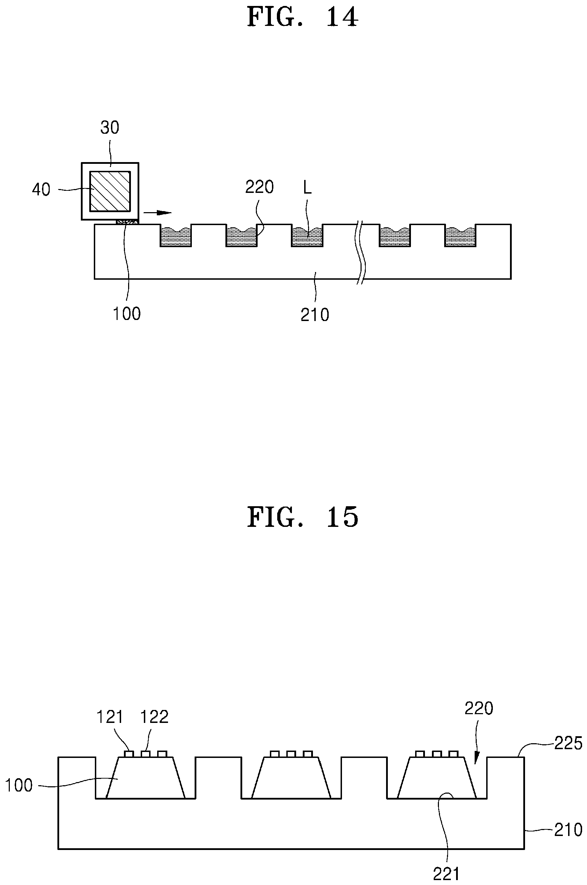

FIG. 14 schematically shows a scanning process for aligning the microchip 100. Referring to FIG. 14, an absorber 30 may scan the transfer substrate 210. While passing through the plurality of grooves 220 in contact with the transfer substrate 210 according to the scanning, the absorber 30 may move the microchip 100 into the groove 220, and may also absorb the liquid L in the groove 220. A material of the absorber 30 may be any material as long as it is a material that may absorb the liquid L, and its shape or structure is not limited. The absorber 30 may include, for example, fabric, tissue, polyester fiber, paper, or a wiper.

The absorber 30 may be used alone without other auxiliary devices, but is not limited thereto, and may be coupled to the support 40 for convenient scanning of the transfer substrate 210. The support 40 may have various shapes and structures suitable for scanning the transfer substrate 210. For example, the support 40 may have the form of a rod, a blade, a plate, a wiper, or the like. The absorber 30 may be provided on either side of the support 40 or wrap around the support 40. The shape of the support 40 and the absorber 30 is not limited to the illustrated rectangular cross-sectional shape, and may have a circular cross-sectional shape.

The absorber 30 may be scanned while pressing the transfer substrate 210 to an appropriate pressure. Scanning may be performed in various methods, for example, a sliding method, a rotating method, a translating motion method, a reciprocating motion method, a rolling method, a spinning method, and/or a rubbing method of the absorber 30, and may include both a regular manner and an irregular manner. Scanning may be performed by moving the transfer substrate 210 instead of moving the absorber 30, and scanning of the transfer substrate 210 may also be performed in a manner such as a sliding, rotating, translational reciprocating, rolling, spinning, and/or rubbing method. In addition, scanning may be performed by the cooperation of the absorber 30 and the transfer substrate 210.

The operation of supplying the liquid L to the groove 220 of the transfer substrate 210 and the operation of supplying the microchip100 to the transfer substrate 210 may be performed in the reverse order to the above-described order. In addition, it is also possible that the operation of supplying the liquid L to the groove 220 of the transfer substrate 210 and the operation of supplying the microchip 100 to the transfer substrate 210 are simultaneously performed in one operation. For example, by supplying a suspension including the microchip 100 to the transfer substrate 210, the liquid L and the microchip 100 may be simultaneously supplied to the transfer substrate 210. After the absorber 30 scans the transfer substrate 210, the microchip 100 remaining in the transfer substrate 210 without entering the groove 220 may be removed. The above-described processes may be repeated until the microchip 100 is seated in all the grooves 220. As described above, a large number of microchips 100 may be aligned on a large-area transfer substrate 210 using a fluidic self assembly method.

FIG. 15 is a cross-sectional view showing a schematic structure of a transfer substrate 210 according to an example embodiment in which the microchips 100 are arranged. Referring to FIG. 15, the transfer substrate 210 may include a partition wall 225 provided adjacent to and surrounding the plurality of grooves 220. The partition wall 225 may be made of a flexible polymer material. For example, the partition wall 225 may include at least one of an acrylic polymer, a silicone-based polymer, and an epoxy-based polymer. In addition, the partition wall 225 may further include a photosensitive material. When the partition wall 225 includes a photosensitive material, a plurality of grooves 220 may be formed by a photolithography method. When the partition wall 225 does not include a photosensitive material, the plurality of grooves 220 may be formed by etching and molding. The thickness of the partition wall 225 may be slightly greater than or slightly less than the thickness of the microchip 100. For example, the thickness of the partition wall 225 may be about 0.8 to about 1.2 times the thickness of the microchip 100.

Using the above-described fluidic self assembly method, one microchip 100 may be disposed in each groove 220. In this case, the partition wall 225 may be provided adjacent to and surround the microchip 100. In the microchip 100, the first and second electrodes 121 and 122 face upward, that is, toward the outside of the groove 220, and the planarization layer 115 (refer to FIG. 5) may be disposed such that the lower surface of the planarization layer 115 contacts the bottom surface 221 of the groove 220. For this, the bottom surface 221 of the groove 220 that comes into contact with the lower surface of the planarization layer 115 (refer to FIG. 5) may be made of a dielectric material having high hydrophilicity and a relatively highly smooth surface. For example, the rms roughness of the bottom surface 221 of the groove 220 may be about 1 nm or less, or about 0.5 nm or less. Therefore, when the planarization layer 115 (refer to FIG. 5) comes into contact with the bottom surface 221 of the groove 220 during the fluidic self assembly process, due to the van der Waals force, the microchip 100 may settle in the groove 220 without exiting the groove 220.

When the first and second electrodes 121 and 122 contact the bottom surface 221 of the groove 220 within the groove 220, since the van der Waals force is relatively small, the microchip 100 may easily come out of the groove 220 even with a weak force. Therefore, when aligning the microchip 100 using the fluidic self assembly method, the first and second electrodes 121 and 122 of the microchip 100 fixed in the groove 220 may face the outside of the groove 220. In addition, the first and second electrodes 121 and 122 may allow the microchip 100 that is not fixed in the groove 220 and remains on the partition wall 225 to be more easily separated from the transfer substrate 210 in the cleaning operation. In this regard, the disclosed microchip 100 may have a structure suitable for alignment in a fluidic self assembly method. A concave-convex pattern may be further formed on the upper surface of the partition wall 225 so that the microchip 100 may be more easily separated from the partition wall 225.

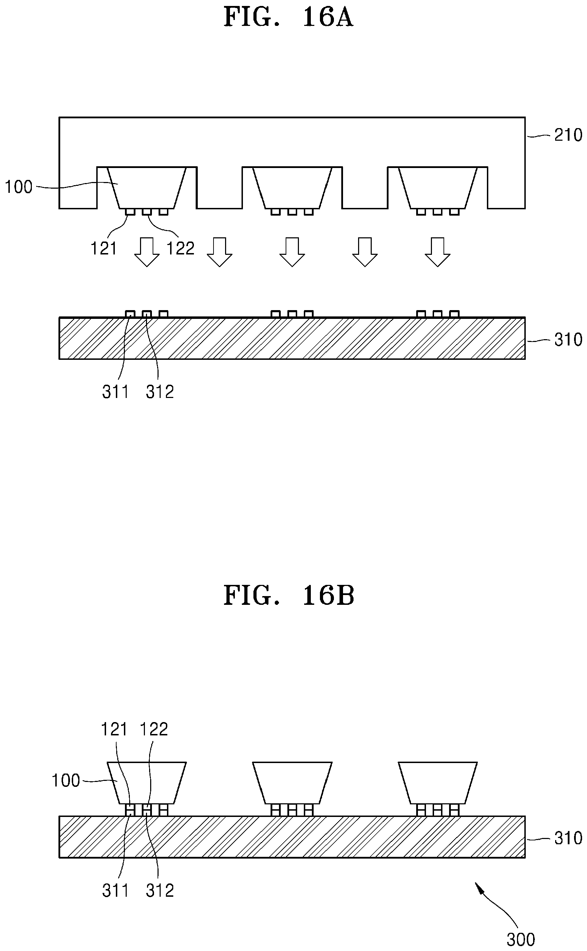

The plurality of microchips 100 aligned on the transfer substrate 210 may be transferred onto the display substrate of the display apparatus for manufacturing the display apparatus. FIGS. 16A and 16B are cross-sectional views schematically illustrating a process of manufacturing a display apparatus according to an example embodiment by transferring the microchip 100 aligned on the transfer substrate 210 onto the display substrate.

Referring to FIG. 16A, the display substrate 310 may include a plurality of first electrode pads 311 and a plurality of second electrode pads 312 disposed on the upper surface of the display substrate 310. The display substrate 310 may further include a driving circuit including a plurality of thin film transistors for independently controlling the plurality of microchips 100. For example, a plurality of thin film transistors are disposed under the first electrode pad 311 and the second electrode pad 312 in the display substrate 310, and the plurality of thin film transistors may be electrically connected to the first and second electrode pads 311 and 312 through wiring not shown.

The transfer substrate 210 may be disposed such that the first and second electrodes 121 and 122 of the microchip 100 face the display substrate 310. Then, the transfer substrate 210 may be pressed onto the display substrate 310 such that the first electrode 121 of the microchip 100 is in contact with the first electrode pad 311 of the display substrate 310 and the second electrode 122 is in contact with the second electrode pad 312 of the display substrate 310. Then, the first electrode 121 may be bonded to the first electrode pad 311 and the second electrode 122 may be bonded to the second electrode pad 312 through a bonding material such as solder bumps.

Referring to FIG. 16B, when the microchip 100 is completely fixed to the display substrate 310, the transfer substrate 210 may be removed from the microchip 100. As described above, by using the microchip 100 having a structure suitable for alignment in the fluidic self-assembly method, the large-area display apparatus 300 may be relatively easily manufactured in the fluidic self-assembly method. As shown in FIG. 16B, the display apparatus 300 according to the embodiment may include a display substrate 310 having a driving circuit and a plurality of microchips 100 arranged on the display substrate 310.

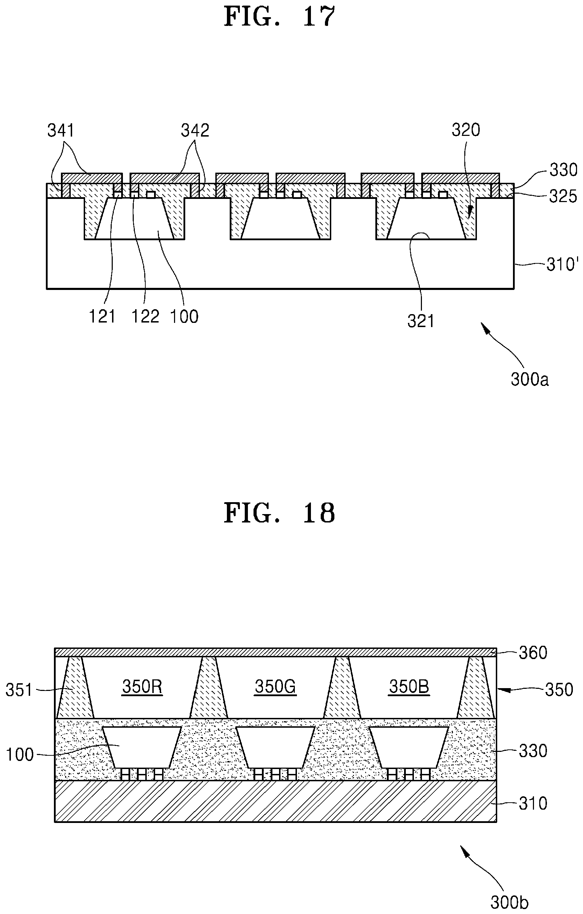

FIG. 17 is a cross-sectional view schematically illustrating a structure of a display apparatus according to another example embodiment. Referring to FIG. 17, the display substrate 310' of the display apparatus 300a may be configured to also serve as a transfer substrate. In this case, after aligning the plurality of microchips 100 on the transfer substrate, the plurality of microchips 100 may be directly aligned on the display substrate 310' without the need to transfer the plurality of microchips 100 to a separate display substrate. To this end, the display substrate 310' may include a plurality of grooves 320 and a partition wall 325 provided adjacent to and surrounding the plurality of grooves 320. Each of the plurality of microchips 100 may be disposed in a corresponding groove 320 among the plurality of grooves 320. The plurality of microchips 100 may be arranged so that the lower surface of each microchip 100 contacts the bottom surface 321 of the groove 320 in the corresponding groove 320.

In addition, the display apparatus 300a may further include an insulating layer 330 disposed to cover the plurality of microchips 100 and to fill the plurality of grooves 320, a first wiring 341 electrically connected to the first electrode 121 of the microchip 100, and a second wiring 342 electrically connected to the second electrode 122 of the microchip 100. The first wiring 341 and the second wiring 342 may be disposed on the insulating layer 330. The first end of the first wiring 341 may penetrate the insulating layer 330 and contact the first electrode 121, and the second end may be connected to the driving circuit inside the display substrate 310' through the insulating layer 330 and the partition wall 325. The first end of the second wiring 342 may penetrate the insulating layer 330 and contact the second electrode 122, and the second end may be connected to the driving circuit inside the display substrate 310' through the insulating layer 330 and the partition wall 325. The insulating layer 330, the first wiring 341, and the second wiring 342 may be formed after aligning the plurality of microchips 100 in the plurality of grooves 320 of the display substrate 310'.

FIG. 18 is a cross-sectional view schematically illustrating a structure of a display apparatus according to another example embodiment. Referring to FIG. 18, the display apparatus 300b may include a display substrate 310, a plurality of microchips 100 mounted on the display substrate 310, an insulating layer 330 disposed on the display substrate 310 to cover the plurality of microchips 100 and to fill between the plurality of microchips 100, and a wavelength conversion layer 350 disposed on the insulating layer 330. In addition, the display apparatus 300b may further include an upper substrate 360 disposed on the wavelength conversion layer 350.

The wavelength conversion layer 350 may include a first wavelength conversion layer 350R for converting the light emitted from the microchip 100 into light of a first wavelength band, a second wavelength conversion layer 350G for converting light of a second wavelength band different from the first wavelength band, and a third wavelength conversion layer 350B for converting light of a third wavelength band different from the first and second wavelength bands. For example, the light of the first wavelength band may be red light, the light of the second wavelength band may be green light, and the light of the third wavelength band may be blue light. The first wavelength conversion layer 350R, the second wavelength conversion layer 350G, and the third wavelength conversion layer 350B are spaced apart with

EP 4 290 567 A1

a partition 351 disposed therebetween, and may be disposed to face the corresponding microchip 100, respectively.

When the microchip 100 emits blue light, the third wavelength conversion layer 350B may include a resin that transmits blue light. The second wavelength conversion layer 350G may convert blue light emitted from the microchip 100 to emit green light. The second wavelength conversion layer 350G may include quantum dots or phosphor that are excited by blue light to emit green light. The first wavelength conversion layer 350R may change the blue light emitted from the microchip 100 into red light to be emitted. The first wavelength conversion layer 350R may include quantum dots or phosphors that are excited by blue light to emit red light.

The quantum dots included in the first wavelength conversion layer 350R or the second wavelength conversion layer 350G may have a core-shell structure having a core portion and a shell portion, or may have a particle structure without a shell. The core-shell structure may be a single-shell or multi-shell structure, such as a double-shell structure. The quantum dots may include a group II-VI series semiconductor, a group III-V series semiconductor, a group IV-VI series semiconductor, a group IV series semiconductor, and/or graphene quantum dots. The quantum dots may include, for example, cadmium (Cd), selenide (Se), zinc (Zn), sulfur (S) and/or indium phosphide (InP), and each quantum dot may have a diameter of several tens of nm or less, for example, a diameter of about 10 nm or less. The quantum dots included in the first wavelength conversion layer 350R and the second wavelength conversion layer 350G may have different sizes.

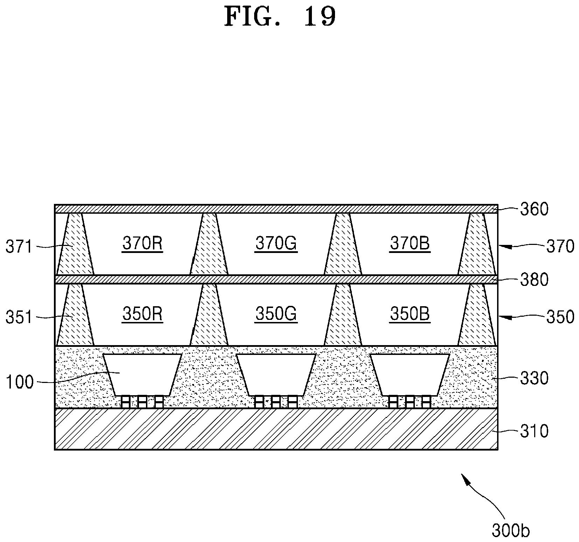

FIG. 19 is a cross-sectional view schematically showing the structure of a display apparatus according to another example embodiment. Referring to FIG. 19, the display apparatus 300c may further include a protective layer 380 disposed on the wavelength conversion layer 350 and a color filter layer 370 disposed on the protective layer 380. The color filter layer 370 may be disposed between the wavelength conversion layer 350 and the upper substrate 360 of the display apparatus 300b shown in FIG. 18. The color filter layer 370 includes a first filter 370R, a second filter 370G, and a third filter 370B spaced apart from each other with a black matrix 371 therebetween. The first filter 370R, the second filter 370G, and the third filter 370B are disposed facing the first wavelength conversion layer 350R, the second wavelength conversion layer 350G, and the third wavelength conversion layer 350B, respectively. The first filter 370R, the second filter 370G, and the third filter 370B transmit red light, green light, and blue light, respectively, and absorb light of different colors. When the color filter layer 370 is provided, light other than red light emitted without wavelength conversion in the first wavelength conversion layer 350R, or light other than the green light emitted without wavelength conversion in the second wavelength conversion layer 350G may be removed by the first filter 370R and the second filter 370G, respectively, so that the color purity of the display apparatus 300c may be increased.

In FIGS. 18 and 19, the wavelength conversion layer 350 and the color filter layer 370 are illustrated as being applied on the display apparatus 300 illustrated in FIG. 16B, but embodiments are not limited thereto. For example, the wavelength conversion layer 350 shown in FIG. 18 and/or the color filter layer 370 shown in FIG. 19 may be applied also on the display apparatus 300a shown in FIG. 17.

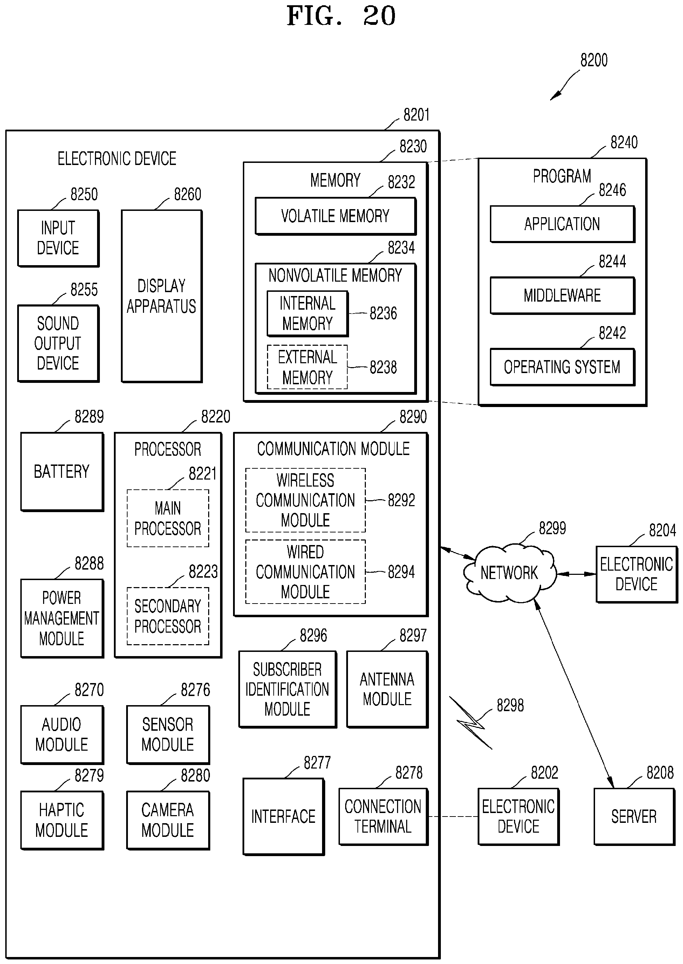

The above-described display apparatuses may be applied to various electronic devices having a screen display function. FIG. 20 is a schematic block diagram of an electronic device according to an example embodiment. Referring to FIG. 20, an electronic device 8201 may be provided in a network environment 8200. In the network environment 8200, the electronic device 8201 may communicate with another electronic device 8202 through a first network 8298 (such as a short-range wireless communication network, and the like), or communicate with another electronic device 8204 and/or a server 8208 through a second network 8299 (such as a remote wireless communication network). The electronic device 8201 may communicate with the electronic device 8204 through the server 8208. The electronic device 8201 may include a processor 8220, a memory 8230, an input device 8250, an audio output device 8255, a display device 8260, an audio module 8270, a sensor module 8276, and an interface 8277, a haptic module 8279, a camera module 8280, a power management module 8288, a battery 8289, a communication module 8290, a subscriber identification module 8296, and/or an antenna module 8297. In the electronic device 8201, some of these components may be omitted or other components may be added. Some of these components may be implemented as one integrated circuit. For example, the sensor module 8276 (fingerprint sensor, iris sensor, illuminance sensor, etc.) may be implemented by being embedded in the display apparatus 8260 (display, etc.).

The processor 8220 may execute software (the program 8240, etc.) to control one or a plurality of other components (such as hardware, software components, etc.) of the electronic device 8201 connected to the processor 8220, and perform various data processing or operations. As part of data processing or operation, the processor 8220 may load commands and/or data received from other components (the sensor module 8276, the communication module 8290, etc.) into the volatile memory 8232, process commands and/or data stored in the volatile memory 8232, and store result data in the nonvolatile memory 8234. The nonvolatile memory 8234 may include an internal memory 8236 mounted in the electronic device 8201 and a removable external memory 8238. The processor 8220 may include a main processor 8221 (such as a central processing unit, an application processor, etc.) and a secondary processor 8223 (such as a graphics processing unit, an image signal processor, a sensor hub processor, a communication processor, etc.) that may be operated independently or together. The secondary processor 8223 may use less power than the main processor 8221 and may perform specialized functions.

12

The secondary processor 8223 may control functions and/or states related to some of the components of the electronic device 8201 (such as the display apparatus 8260, the sensor module 8276, the communication module 8290, etc.) instead of the main processor 8221 while the main processor 8221 is in an inactive state (sleep state), or with the main processor 8221 while the main processor 8221 is in an active state (application execution state). The secondary processor 8223 (such as an image signal processor, a communication processor, etc.) may be implemented as part of other functionally related components (such as the camera module 8280, the communication module 8290, etc.).

The memory 8230 may store various data required by components of the electronic device 8201 (such as the processor 8220, the sensor module 8276, etc.). The data may include, for example, software (such as the program 8240, etc.) and input data and/or output data for commands related thereto. The memory 8230 may include a volatile memory 8232 and/or a nonvolatile memory 8234.

The program 8240 may be stored as software in the memory 8230 and may include an operating system 8242, a middleware 8244, and/or an application 8246.

The input device 8250 may receive commands and/or data to be used for components (such as the processor 8220, etc.) of the electronic device 8201 from outside (a user) of the electronic device 8201. The input device 8250 may include a remote controller, a microphone, a mouse, a keyboard, and/or a digital pen (such as a stylus pen).

The audio output device 8255 may output an audio signal to the outside of the electronic device 8201. The audio output device 8255 may include a speaker and/or a receiver. The speaker may be used for general purposes such as multimedia playback or recording playback, and the receiver may be used to receive incoming calls. The receiver may be combined as a part of the speaker or may be implemented as an independent separate device.

The display apparatus 8260 may visually provide information to the outside of the electronic device 8201. The display apparatus 8260 may include a display, a hologram device, or a projector and a control circuit for controlling the device. The display apparatus 8260 may include the aforementioned display substrate and microchip. The display apparatus 8260 may include a touch circuitry set to sense a touch, and/or a sensor circuit (such as a pressure sensor) set to measure the strength of a force generated by the touch.

The audio module 8270 may convert sound into an electrical signal, or conversely, may convert an electrical signal into sound. The audio module 8270 may acquire sound through the input device 8250 or output sound through speakers and/or headphones of the audio output device 8255, and/or other electronic devices (such as the electronic device 8202) directly or wirelessly connected to the electronic device 8201.

The sensor module 8276 may detect an operating state (such as power, temperature, and the like) of the electronic device 8201 or an external environmental state (such as a user state, and the like), and generate an electrical signal and/or data value corresponding to the detected state. The sensor module 8276 may include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more specified protocols that may be used for the electronic device 8201 to connect directly or wirelessly with another electronic device (such as the electronic device 8202). The interface 8277 may include a High Definition Multimedia Interface (HDMI), a Universal Serial Bus (USB) interface, an SD card interface, and/or an audio interface.

The connection terminal 8278 may include a connector through which the electronic device 8201 may be physically connected to another electronic device (such as the electronic device 8202). The connection terminal 8278 may include an HDMI connector, a USB connector, an SD card connector, and/or an audio connector (such as a headphone connector).

The haptic module 8279 may convert an electrical signal into a mechanical stimulus (such as vibration, movement, etc.) or an electrical stimulus that a user may perceive through a tactile or motor sense. The haptic module 8279 may include a motor, a piezoelectric element, and/or an electrical stimulation device.

The camera module 8280 may capture a still image and a video. The camera module 8280 may include a lens assembly including one or more lenses, image sensors, image signal processors, and/or flashes. The lens assembly included in the camera module 8280 may collect light emitted from a subject that is a target of image capturing.

The power management module 8288 may manage power supplied to the electronic device 8201. The power management module 8388 may be implemented as a part of a Power Management Integrated Circuit (PMIC).

The battery 8289 may supply power to components of the electronic device 8201. The battery 8289 may include a non-rechargeable primary cell, a rechargeable secondary cell, and/or a fuel cell.

The communication module 8290 may support establishing a direct (wired) communication channel and/or a wireless communication channel, and performing communication through the established communication channel between the electronic device 8201 and other electronic devices (such as the electronic device 8202, the electronic device 8204, the server 8208, and the like). The communication module 8290 may include one or more communication processors that operate independently of the processor 8220 (such as an application processor) and support direct communication and/or wireless communication. The communication module 8290 may include a wireless communication module 8292 (such as a cellular communication module, a short-range wireless communication module, a Global Navigation Satellite System (GNSS) communication module, and the like) and/or a wired communication module 8294 (such as a local area network (LAN) communication module, a power line communication module, and the like). Among these communication modules, a corresponding communication module may communicate with other electronic devices through a first network 8298 (a short-range communication network such as Bluetooth, WiFi Direct, or Infrared Data Association (IrDA)) or a second network 8299 (a cellular network, the Internet, or a telecommunication network such as a computer network (such as LAN, WAN, and the like)). These various types of communication modules may be integrated into one component (such as a single chip, and the like), or may be implemented as a plurality of separate components (a plurality of chips). The wireless communication module 8292 may check and authenticate the electronic device 8201 in a communication network such as the first network 8298 and/or the second network 8299 using the subscriber information (such as international mobile subscriber identifier (IMSI), etc.) stored in the subscriber identification module 8296.

The antenna module 8297 may transmit signals and/or power to the outside (such as other electronic devices) or receive signals and/or power from the outside. The antenna may include a radiator made of a conductive pattern formed on a substrate (such as PCB, etc.). The antenna module 8297 may include one or a plurality of antennas. If multiple antennas are included, an antenna suitable for a communication method used in a communication network such as the first network 8298 and/or the second network 8299 may be selected from the plurality of antennas by the communication module 8290. Signals and/or power may be transmitted or received between the communication module 8290 and another electronic device through the selected antenna. In addition to the antenna, other components (such as RFIC) may be included as part of the antenna module 8297.

Some of the components are connected to each other and may exchange signals (such as commands, data, and the like) through communication method between peripheral devices (such as bus, General Purpose Input and Output (GPIO), Serial Peripheral Interface (SPI), Mobile Industry Processor Interface (MIPI), and the like).

The command or data may be transmitted or received between the electronic device 8201 and the external electronic device 8204 through the server 8208 connected to the second network 8299. The other electronic devices 8202 and 8204 may be the same or different types of devices as or from the electronic device 8201. All or some of the operations executed by the electronic device 8201 may be executed by one or more of the other electronic devices 8202, 8204, and 8208. For example, when the electronic device 8201 needs to perform a certain function or service, instead of executing the function or service itself, the electronic device 8201 may request one or more other electronic devices to perform the function or part or all of the service. One or more other electronic devices that receive the request may execute an additional function or service related to the request, and transmit a result of the execution to the electronic device 8201. For this, cloud computing, distributed computing, and/or client-server computing technology may be used.

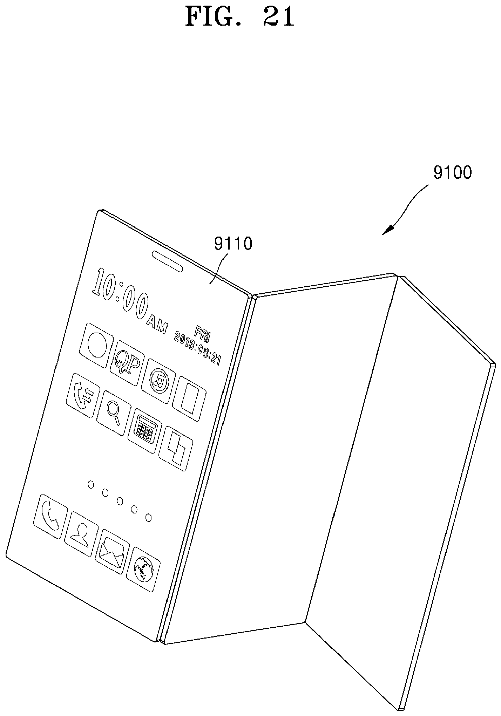

FIG. 21 illustrates an example in which a display apparatus according to example embodiments is applied to a mobile device. The mobile device 9100 may include the display apparatus 9110, and the display apparatus 9110 may include the above-described display substrate and microchip. The display apparatus 9110 may have a foldable structure, for example, a multi-foldable structure.

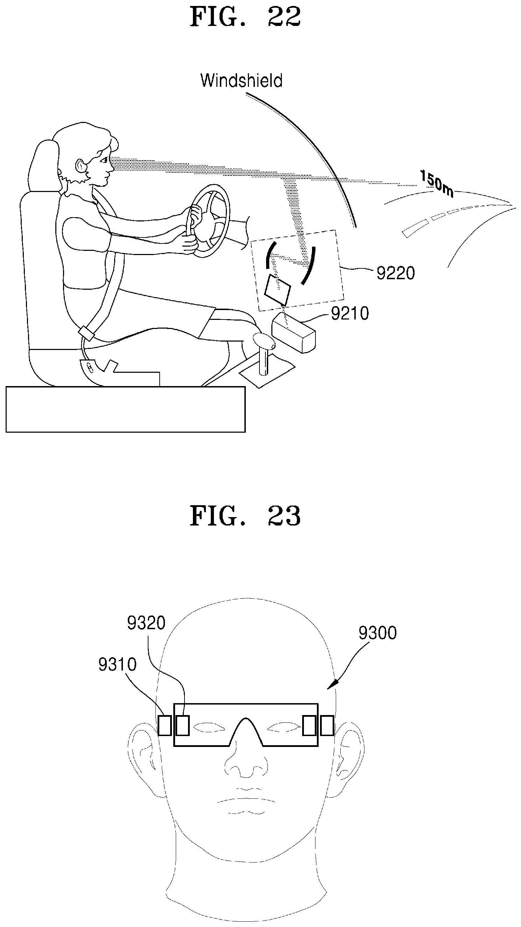

FIG. 22 illustrates an example in which the display apparatus according to the example embodiments is applied to a vehicle display apparatus. The display apparatus may be a vehicle head-up display apparatus 9200, and may include a display 9210 provided in an area of the vehicle, and a light path changing member 9220 that converts an optical path so that the driver may see the image generated on the display 9210.

FIG. 23 illustrates an example in which a display apparatus according to example embodiments is applied to augmented reality glasses or virtual reality glasses. The augmented reality glasses 9300 may include a projection system 9310 that forms an image, and an element 9320 that guides the image from the projection system 9310 into the user's eye. The projection system 9310 may include the aforementioned display substrate and microchip.

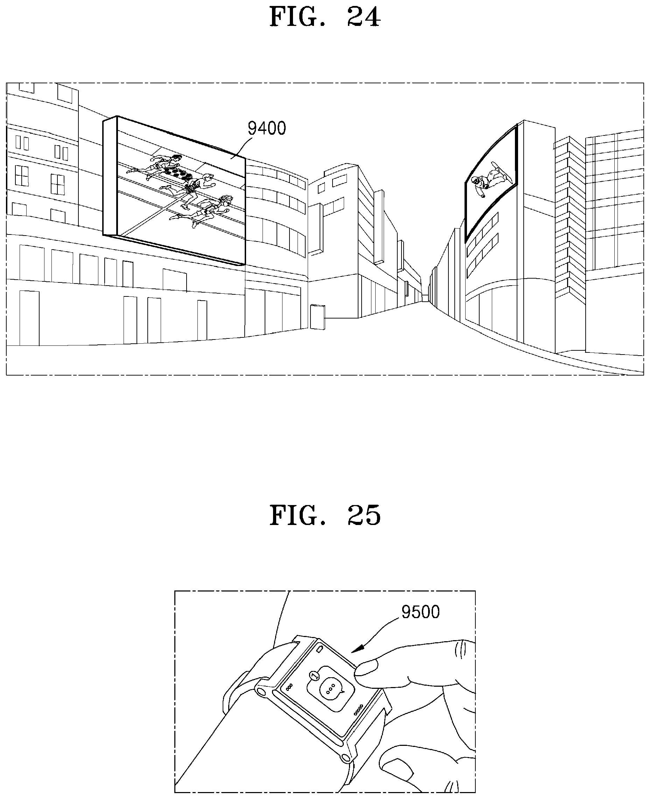

FIG. 24 shows an example in which the display apparatus according to the example embodiments is applied to a signage. A signage 9400 may be used for outdoor advertisement using a digital information display, and may control advertisement contents and the like through a communication network. The signage 9400 may be implemented, for example, through the electronic device described with reference to FIG. 20.

FIG. 25 illustrates an example in which a display apparatus according to example embodiments is applied to a wearable display. The wearable display 9500 may include the above-described display substrate and microchip, and may be implemented through the electronic device described with reference to FIG. 20.

The display apparatus according to an example embodiment may also be applied to various products such as a rollable television (TV) and a stretchable display.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims and their equivalents.

**Claims**

1. A microchip comprising:

   a chip body having a first surface and a second surface facing the first surface; and
   an electrode layer on the second surface,
   wherein a surface roughness of the first surface is smaller than a surface roughness of an upper surface of the electrode layer such that van der Waals force between the first surface and an external contact surface are greater than van der Waals force between the electrode layer and the external contact surface.

2. The microchip of claim 1, wherein a width of the first surface is greater than a distance between the first surface and the upper surface of the electrode layer.

3. The microchip of claim 1 or 2, wherein a width of the first surface is in a range from 5 $\mu$m to 500 $\mu$m.

4. The microchip of any preceding claim, wherein a distance between the first surface and the upper surface of the electrode layer is in a range from 1 $\mu$m to 100 $\mu$m.

5. The microchip of any preceding claim, wherein a root mean square, rms, roughness of the first surface is less than or equal to 1 nm, and a rms roughness of the upper surface of the electrode layer is greater than or equal to 2 nm, and optionally wherein the rms roughness of the first surface has a uniformity within $\pm$20% over an entire area of the first surface, and the rms roughness of the upper surface of the electrode layer has a uniformity of at least $\pm$30% over an entire area of the upper surface of the electrode layer.

6. The microchip of any preceding claim, wherein an area of the first surface is greater than an area of the second surface.

7. The microchip of any preceding claim, wherein the chip body comprises:

   a first semiconductor layer doped with a first conductivity type;
   a light-emitting layer on an upper surface of the first semiconductor layer;
   a second semiconductor layer on an upper surface of the light-emitting layer and doped with a second conductivity type electrically opposite to the first conductivity type;
   an insulating layer on an upper surface of the second semiconductor layer; and
   a planarization layer on a lower surface of the first semiconductor layer,
   wherein the first surface is a lower surface of the planarization layer and the second surface is an upper surface of the insulating layer, and optionally wherein the electrode layer comprises:

      a first electrode on the upper surface of the insulating layer and electrically connected to the first semiconductor layer; and
      a second electrode on the upper surface of the insulating layer and electrically connected to the second semiconductor layer.

8. The microchip of claim 7, wherein the planarization layer comprises at least one of aluminum nitride, polyimide, and parylene.

9. The microchip of claim 7 or 8, further comprising a plurality of light-scattering patterns in the first semiconductor layer, and optionally wherein the light-scattering patterns penetrate the planarization layer and have an engraved form protruding from the lower surface of the first semiconductor layer, and further optionally wherein the first surface is a single surface that is not separated by the light-scattering patterns.

10. The microchip of claim 9, wherein the plurality of light-scattering patterns have an engraved form protruding from the lower surface of the first semiconductor layer in contact with an upper surface of the planarization layer.

11. The microchip of claim 7 or 8, further comprising a plurality of light-scattering patterns having an engraved form protruding from an upper surface of the planarization layer in contact with the first semiconductor layer.

**12.** The microchip of any preceding claim, wherein the first surface is hydrophilic.

**13.** The microchip of any preceding claim, wherein the microchip comprises at least one of a light-emitting diode, LED, a laser diode, a photodiode, a complementary metal-oxide-semiconductor, CMOS, a high-electron-mobility transistor, HEMT, a thin-film battery, and an antenna element.

**14.** A display apparatus comprising:

a display substrate comprising a driving circuit; and
a plurality of microchips on the display substrate,
wherein each of the plurality of microchips is the microchip according to any preceding claim.

**15.** The display apparatus of claim 14, wherein the display substrate comprises:

a plurality of grooves; and
a partition wall adjacent to the plurality of grooves,
wherein each of the plurality of microchips is in a corresponding groove among the plurality of grooves,
wherein each of the plurality of microchips is disposed such that the first surface contacts a bottom surface of the groove within the groove, and
wherein in each groove, a bottom surface of the groove has a root mean square, rms roughness less than or equal to 1 nm.

# FIG. 1

# FIG. 2

Moving & Fixing

Stable

# FIG. 3

Force

Unstable

Flip-down

# FIG. 4

# FIG. 5

# FIG. 6A

# FIG. 6B

# FIG. 6C

# FIG. 6D

## FIG. 7A

## FIG. 7B

FIG. 8A

FIG. 8B

## FIG. 8C

250 nm

B

$R_q = 0.48$ nm

−250 nm

# FIG. 9A

Average = 8.08±3.78 nN

# FIG. 9B

Average = 9.03±1.68 nN

# FIG. 10

# FIG. 11

# FIG. 12A

# FIG. 12B

# FIG. 13

# FIG. 14

# FIG. 15

# FIG. 16A

# FIG. 16B

## FIG. 17

## FIG. 18

# FIG. 19

371 — 370R   370G   370B — 370
351 — 350R   350G   350B — 350
100 — 330
310

300b

# FIG. 20

# FIG. 21

# FIG. 22

Windshield

150m

9220

9210

# FIG. 23

9320

9310

9300

FIG. 24

9400

FIG. 25

9500

| | Europäisches Patentamt<br>European Patent Office<br>Office européen des brevets | **EUROPEAN SEARCH REPORT** | Application Number<br>**EP 22 20 5150** |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2008/054290 A1 (SHIEH YUH-REN [TW] ET AL) 6 March 2008 (2008-03-06)<br>* paragraphs [0017] - [0021]; figures 2-7 * | 1-6, 12-15<br>7-11 | INV.<br>H01L23/00<br>H01L33/38<br>B81C3/00 |
| A | US 2022/013400 A1 (HWANG KYUNGWOOK [KR] ET AL) 13 January 2022 (2022-01-13)<br>* paragraphs [0078] - [0160]; figures 1-41 * | 1-15 | ADD.<br>H01L25/075<br>H01L25/16<br>H01L33/00<br>H01L27/146 |
| A | YEH H-J J ET AL: "FLUIDIC SELF-ASSEMBLY OF MICROSTRUCTURES AND ITS APPLICATION TO THEINTEGRATION OF GAAS ON SI",<br>PROCEEDING OF THE WORKSHOP ON MICRO ELECTRO MECHANICAL SYSTEMS (MEMS). OISO, JAN. 25 - 28, 1994; [PROCEEDING OF THE WORKSHOP ON MICRO ELECTRO MECHANICAL SYSTEMS (MEMS)], NEW YORK, IEEE, US,<br>vol. WORKSHOP 7,<br>25 January 1994 (1994-01-25), pages 279-284, XP000528430,<br>ISBN: 978-0-7803-1834-2<br>* the whole document * | 1-15 | |
| A | US 6 300 149 B1 (SMITH CHARLES GORDON [GB]) 9 October 2001 (2001-10-09)<br>* column 3, line 1 - column 4, line 55; figures 5-8 * | 1-15 | TECHNICAL FIELDS SEARCHED (IPC)<br>H01L<br>B82B<br>B81C |

-/--

The present search report has been drawn up for all claims

| Place of search | Date of completion of the search | Examiner |
|---|---|---|
| The Hague | 21 August 2023 | Albrecht, Claus |

EPO FORM 1503 03.82 (P04C01)

## EUROPEAN SEARCH REPORT

Application Number

EP 22 20 5150

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FUKUSHIMA T ET AL: "New chip-to-wafer 3D integration technology using hybrid self-assembly and electrostatic temporary bonding", 2012 INTERNATIONAL ELECTRON DEVICES MEETING (IEDM 2012) : SAN FRANCISCO, CALIFORNIA, USA, 10 - 13 DECEMBER 2012, IEEE, PISCATAWAY, NJ, 10 December 2012 (2012-12-10), pages 33.3.1-33.3.4, XP032341849, DOI: 10.1109/IEDM.2012.6479157 ISBN: 978-1-4673-4872-0 * the whole document * | 1-15 | |

TECHNICAL FIELDS SEARCHED (IPC)

The present search report has been drawn up for all claims

| Place of search | Date of completion of the search | Examiner |
|---|---|---|
| The Hague | 21 August 2023 | Albrecht, Claus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 2 of 2

EP 4 290 567 A1

## ANNEX TO THE EUROPEAN SEARCH REPORT
## ON EUROPEAN PATENT APPLICATION NO.

EP 22 20 5150

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2023

| Patent document cited in search report | | Publication date | Patent family member(s) | | Publication date |
|---|---|---|---|---|---|
| US 2008054290 | A1 | 06-03-2008 | TW | 200814350 A | 16-03-2008 |
| | | | US | 2008054290 A1 | 06-03-2008 |
| | | | US | 2012040480 A1 | 16-02-2012 |
| US 2022013400 | A1 | 13-01-2022 | CN | 113921421 A | 11-01-2022 |
| | | | EP | 3937263 A1 | 12-01-2022 |
| | | | JP | 2022016417 A | 21-01-2022 |
| | | | US | 2022013400 A1 | 13-01-2022 |
| US 6300149 | B1 | 09-10-2001 | AT | 279786 T | 15-10-2004 |
| | | | AU | 3778397 A | 25-02-1998 |
| | | | CA | 2261864 A1 | 12-02-1998 |
| | | | DE | 69731208 T2 | 17-02-2005 |
| | | | EP | 0917733 A1 | 26-05-1999 |
| | | | JP | 2000516394 A | 05-12-2000 |
| | | | US | 6300149 B1 | 09-10-2001 |
| | | | WO | 9806132 A1 | 12-02-1998 |

EPO FORM P0459

For more details about this annex : see Official Journal of the European Patent Office, No. 12/82